# EUROPÄISCHE PATENTANMELDUNG

(11) **EP 1 164 699 A1**
(43) Veröffentlichungstag der Anmeldung: **19.12.2001**
(21) Anmeldenummer: 00112586.3
(22) Anmeldetag: 14.06.2000
(51) Int. Cl.: H03K 19/0175

(54) **Schaltungsanordnung zur Umsetzung von Logikpegeln**

(71) Anmelder: Infineon Technologies AG, 81669 München (DE)
(72) Erfinder: Gossmann, Timo, 81739 Muenchen (DE)
(74) Vertreter: Fischer, Volker, Dipl.-Ing.

(57) **Zusammenfassung**

Die Schaltungsanordnung zur Wandlung von Logikpegeln weist eine bipolare Eingangsstufe und eine CMOS-Ausgangsstufe auf. Die bipolare Eingangsstufe ist dazu geeignet, ECL- bzw. CML-Logikpegel zu verarbeiten. Die CMOS-Logik-Ausgangsstufe ist dazu geeignet, nachfolgende CMOS-Gatter mit CMOS-Logikpegeln zu versorgen. Die Schaltungsanordnung umfaßt einen Differenzverstärker mit Bipolartransistoren (1, 2), die an eine gemeinsame Emitterstromquelle (11) und an getrennte Kollektorstromquellen (12, 13) angeschlossen sind. An einem der Kollektoren (5) ist ein eingangs-ausgangsseitig rückgekoppelter CMOS-Inverter (14) angeschlossen, dessen Ausgang mit einem Ausgangsknoten (21) gekoppelt ist.

## Beschreibung

Die vorliegenden Erfindung betrifft eine Schaltungsanordnung zur Umsetzung von Logikpegeln.

Moderne CMOS-Technologien ermöglichen bereits Arbeitsfrequenzen von mehreren 100 MHz. Es ist allerdings bisher nicht praktikabel, eine reine CMOS-Schaltungstechnik in Frequenzbereichen einzusetzen, in denen Mobilfunkanwendungen betrieben werden. Dies sind z.B. Frequenzen um 900 MHz, 1800 MHz und 1900 MHz.

Bei digitaler CMOS-Schaltungstechnik ist es üblich, daß die logischen Zustände High und Low jeweils der oberen bzw. unteren Versorgungsspannung (Rail to Rail Logic) entsprechen. Bei jedem logischen Zustandswechsel von High auf Low bzw. Low auf High muß folglich der komplette Versorgungsspannungsbereich überstrichen werden. Dies bedeutet, daß parasitäre Kapazitäten bei jedem Schaltvorgang maximal umgeladen werden müssen. Dadurch ist der dynamische Leistungsverbrauch einer CMOS-Logik sehr hoch. Ein weiterer Nachteil dieser CMOS-Logik besteht darin, daß durch die Schaltvorgänge starke Störpegel auf dem Versorgungspotential bzw. auf dem Bezugspotential erzeugt werden. Die momentan erreichbaren Rail to Rail-Schaltgeschwindigkeiten sind für den Einsatz in Frequenzbereichen von einigen GHz noch nicht hoch genug, so daß diese Schaltungstechnik noch nicht vernünftig für Anwendungen in Mobilfunkfrequenzbereichen eingesetzt werden kann.

Der Aufbau einer differentiellen Logik mit geringen Unterschieden zwischen logischem High- und Low-Pegel, ähnlich einer von Bipolarschaltungstechnik her bekannten CML- oder ECL-Logik ist daher momentan für höchste Schaltgeschwindigkeiten im GHz-Bereich gebräuchlich.

Bei Verarbeitung geringerer Frequenzen weist Rail to Rail CMOS-Schaltungstechnik einen geringen Platzbedarf, keine statische Leistungsaufnahme und hohe Störfestigkeit sowie die Einsparung von Bias-Strömen und Bias-Spannungen auf. Daher werden in modernen Schaltungsdesigns BICMOS-Prozesse verwendet, in denen ein vollständiger Bipolar- und CMOS-Prozeß vereinigt sind. Die hochfrequent arbeitenden Schaltungsteile werden dabei in bipolarer Schaltungstechnik (CML/ECL) aufgebaut, die niedrigeren Frequenzen werden mit Rail to Rail CMOS-Logiken weiterverarbeitet.

Es tritt das Problem auf, daß eine Schnittstelle zwischen den beiden Schaltungsteilen mit ECL/CML-Logikpegeln und CMOS-Logikpegeln gebildet werden muß. Die ECL/CML-Logikpegel liegen in differentieller Form vor, weisen einen Spannungshub von üblicherweise ca. ± 100 mV auf jeder der beiden Signalleitungen auf und liegen symmetrisch um ein Mittenpotential. Die CMOS-Schaltungsteile sind dagegen mit einer separaten Spannungsversorgung ausgestattet und weisen Logikpegel auf, die von dem CMOS-Versorgungspotential bis zu dem (gemeinsamen) Massepotential reichen.

CMOS-Gatter weisen eine steile Umschaltcharakteristik in einem begrenzten Umschaltspannungsbereich auf, in dem die Gatter schnell schalten. Der Umschaltspannungspunkt eines CMOS-Gatters ist sowohl von der Temperatur, als auch von der Versorgungsspannung, sowie von Prozeßschwankungen bei der Herstellung abhängig. Eine direkte Kopplung bipolarer- und CMOS-Schaltungen ist in der Praxis schwierig, da die Fertigungstoleranzen in bipolaren und im CMOS Schaltungsteil sehr wenig bzw. überhaupt nicht miteinander korrelieren, so daß sie ungünstig streuen und ein korrektes Schaltverhalten aufgrund auseinanderlaufender Bias-Bedingungen nicht mehr sicher gewährleistet ist.

Eine Lösung dieses Problems ist z.B. in dem Patent US 6,008,667 angegeben, die beide Pegel eines differentiellen Logiksignals als Eingangssignal nutzt und die Logikpegel entsprechend umsetzt.

Es ist die Aufgabe der Erfindung eine Schaltung zur Umsetzung von Logikpegeln anzugeben, die eine größere Grenzfrequenz bei einem niedrigeren Rauschfaktor ermöglicht.

Die erfindungsgemäße Aufgabe wird gelöst durch eine Schaltungsanordnung zur Umsetzung von Logikpegeln mit:
- einem ersten Bipolartransistor, der einen Emitter, einen Kollektor und eine Basis aufweist;
- einem zweiten Bipolartransistor, der einen Emitter, einen Kollektor und eine Basis aufweist;
- wobei der Emitter des ersten Bipolartransistors und der Emitter des zweiten Bipolartransistors mit einer ersten Stromquelle verbunden sind und
- der Kollektor des ersten Bipolartransistors mit einer zweiten Stromquelle und
- der Kollektor des zweiten Bipolartransistors mit einer dritten Stromquelle verbunden sind,
- wobei ein eingangs-ausgangsseitig rückgekoppelter erster Inverter mit dem Kollektor des ersten Bipolartransistors verbunden ist und ein Ausgangsknoten vom ersten rückgekoppelten Inverter ansteuerbar ist.

Beim Betrieb der Schaltung wird als Eingangssignal ein differentielles Logiksignal an die Basis des ersten Bipolartransistors und an die Basis des zweiten Bipolartransistors angelegt. Ist an der Basis des ersten Bipolartransistors und der Basis des zweiten Bipolartransistors kein Spannungsunterschied vorhanden, so ist die Summe der beiden in die Kollektoren eingeprägten Ströme gleich dem Strom der durch die gemeinsame Emitterstromquelle fließt. In diesem Fall befindet sich der erste Inverter in einem Ruhezustand. Liegt nun eine Spannungsdifferenz zwischen der ersten Basis und der zweiten Basis vor, so fließt durch einen der Bipolartransistoren ein größerer und durch den anderen Bipolartransistor ein kleinerer Strom. In diesem Fall wird der zusätzliche Strom aus dem Ausgang des ersten Inverters geliefert. Unter einem eingangs-ausgangsseitig rückgekoppelten Inverter wird hier ein Inverter verstanden, dessen Eingang und Ausgang miteinander verbunden sind.

Da sich folglich die Ausgangsspannung des ersten Inverters ändert, kann diese an dem Ausgangsknoten mit einer Referenz verglichen werden, um ein Ausgangssignal mit CMOS-Logikpegeln zu liefern. Der rückgekoppelte Inverter wirkt hierbei wie ein Strom-Spannungswandler, der durch seine Eigenschaft in der Lage ist, einen Knoten niederohmig auf einem Spannungswert zu halten. Dies hat den Vorteil, daß eine größere Grenzfrequenz erreicht wird, da der Inverter eine hohe Treiberleistung aufweist.

In einer Ausgestaltung der Erfindung ist vorgesehen, daß ein eingangs-ausgangsseitig rückgekoppelter zweiter Inverter mit dem Kollektor des zweiten Bipolartransistors verbunden ist und der Ausgangsknoten vom zweiten rückgekoppelten Inverter ansteuerbar ist. Die Ausgangsspannung des ersten rückgekoppelten Inverters kann mit der Ausgangsspannung des zweiten rückgekoppelten Inverters in dem Ausgangsknoten verglichen werden. Da die beiden Bipolartransistoren gegenläufig arbeiten, tritt auch bei den von den beiden rückgekoppelten Invertern erzeugten Signalen eine Gegenläufigkeit auf, die den Signalhub vorteilhaft vergrößert.

Eine weitere Ausgestaltung der erfindungsgemäßen Schaltungsanordnung sieht vor, daß der erste Inverter und der zweite Inverter über einen Stromspiegel gekoppelt sind. Diese Ausgestaltung ist besonders vorteilhaft, da z.B. die an den rückgekoppelten Invertern anliegenden Spannungen mit Transistoren in Ströme gewandelt werden können, die wiederum mittels des Stromspiegels in dem Ausgangsknoten miteinander verglichen werden können.

In einer weiteren Ausgestaltung der Erfindung ist vorgesehen, daß ein erster Transistor und ein zweiter Transistor an einem ersten Knoten mit ihren jeweiligen Drain-Gebieten verbunden sind und ein Gate des ersten Transistors mit dem Kollektor des ersten Bipolartransistors und ein Gate des zweiten Transistors mit dem ersten Knoten verbunden ist und ein dritter Transistor und ein vierter Transistor an dem Ausgangsknoten mit ihren jeweiligen Drain-Gebieten verbunden sind und ein Gate des dritten Transistors mit dem Gate des zweiten Transistors verbunden ist und ein Gate des vierten Transistors mit dem zweiten rückgekoppelten Inverter verbunden ist. Der Vorteil der angegebenen Schaltungsanordnung liegt darin, daß die Ausgangsspannungen des ersten Inverters und des zweiten Inverters mit Hilfe des ersten Transistors, sowie der Stromspiegelvorrichtung, die den zweitem und drittem Transistor umfaßt, in dem Ausgangsknoten mit dem Strom durch den vierten Transistor verglichen werden.

Eine weitere Ausgestaltung der erfindungsgemäßen Schaltungsanordnung sieht vor, daß ein Operationsverstärker mit einem ersten Operationsverstärkereingang und einem zweiten Operationsverstärkereingang und einem Operationsverstärkerausgang so angeordnet ist, daß der erste Operationsverstärkereingang mit einem dritten eingangs-ausgangsseitig rückgekoppelten Inverter verbunden ist und der Operationsverstärkerausgang mit einem Steuereingang der zweiten Stromquelle und einem Steuereingang der dritten Stromquelle verbunden ist. Der Vorteil des Operationsverstärkers liegt darin, daß der Arbeitspunkt des ersten Inverters und des zweiten Inverters mit Hilfe eines dritten rückgekoppelten Inverters eingestellt wird.

Ebenfalls ist in einer Ausgestaltung der Erfindung vorgesehen, daß ein Eingang eines dritten Inverters mit dem Kollektor des ersten Bipolartransistors und ein Ausgang des dritten Inverters mit dem Kollektor des zweiten Bipolartransistors verbunden ist.

Weitere Ausgestaltungen der Erfindung sind Gegenstand der jeweiligen Unteransprüche.

In den Figuren zeigen:
- Figur 1: eine Schaltung zur Umsetzung von Logikpegeln;
- Figur 2: ein weiteres Ausführungsbeispiel einer Schaltung zur Umsetzung von Logikpegeln;
- Figur 3: ein weiteres Ausführungsbeispiel einer Schaltung zur Umsetzung von Logikpegeln.

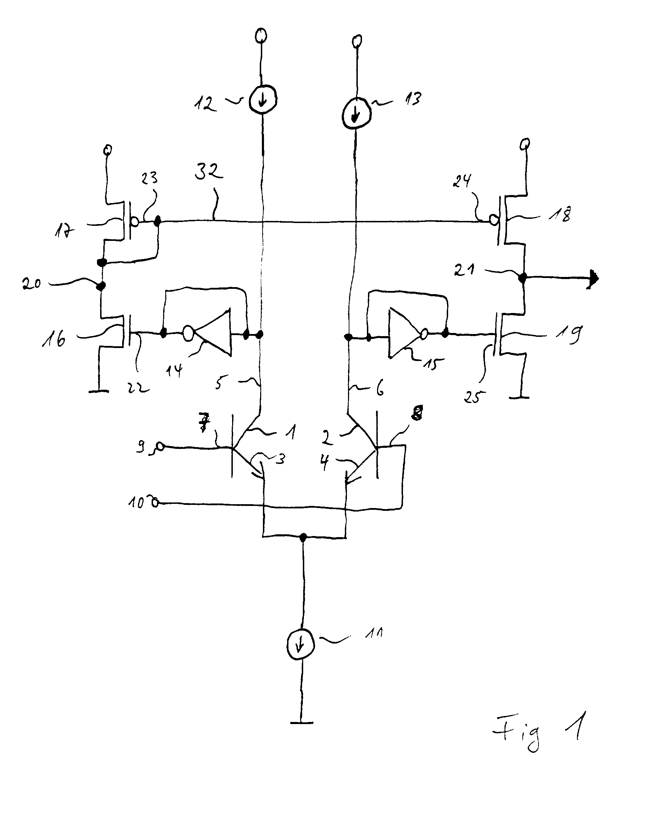

In Figur 1 ist ein erster Bipolartransistor 1 und ein zweiter Bipolartransistor 2 dargestellt. Der erste Bipolartransistor 1 weist einen ersten Emitter 3 einen ersten Kollektor 5 und eine erste Basis 7 auf. Der zweite Bipolartransistor 2 weist einen zweiten Emitter 4, einen zweiten Kollektor 6 und eine zweite Basis 8 auf. Der erste Emitter 3 und der zweite Emitter 4 sind mit einer ersten Stromquelle 11 verbunden. Der erste Kollektor 5 ist mit einer zweiten Stromquelle 12 und der zweite Kollektor 6 mit einer dritten Stromquelle 13 verbunden. Die erste Basis 7 ist mit einem ersten Eingang 9 und die zweite Basis 8 mit einem zweiten Eingang 10 verbunden. Der erste Kollektor 5 ist mit einem ersten rückgekoppelten Inverter 14 verbunden. Der zweite Kollektor 6 ist mit einem zweiten rückgekoppelten Inverter 15 verbunden. Ein erster Transistor 16 und ein zweiter Transistor 17 sind an einem Knoten 20 mit ihren jeweiligen Drain-Gebieten miteinander verbunden und ein Gate 22 des ersten Transistors 16 ist mit dem Kollektor 5 des ersten Bipolartransistors 1 und ein Gate 23 des zweiten Transistors 17 ist mit dem ersten Knoten 20 verbunden. Ein dritter Transistor 24 und ein vierter Transistor 25 sind an einem Ausgangsknoten 21 mit ihren jeweiligen Drain-Gebieten miteinander verbunden und ein Gate 24 des dritten Transistors ist mit dem Gate 23 des zweiten Transistors 17 verbunden und ein Gate 25 des vierten Transistors 19 ist mit dem zweiten rückgekoppelten Inverter 15 verbunden.

Der Ruhezustand der in Figur 1 dargestellten Schaltungsanordnung sieht vor, daß zunächst zwischen dem ersten Eingang 9 und dem zweiten Eingang 10 keine Spannungsdifferenz vorhanden ist. In diesem Zustand fließt durch den ersten Bipolartransistor 1 und den zweiten Bipolartransistor 2 der gleiche Strom, der jeweils von der zweiten Stromquelle 12 bzw. der dritten Stromquelle 13 eingeprägt wird in der Summe den Strom der ersten Stromquelle 11 bildet. In diesem Zustand ist vorgesehen, daß in den ersten rückgekoppelten Inverter 14 und in den zweiten rückgekoppelten Inverter 15 kein Strom fließt. Besteht nun zwischen dem ersten Eingang 9 und dem zweiten Eingang 10 eine Spannungsdifferenz, so ist der Strom durch den ersten Bipolartransistor 1 nicht mehr gleich dem Strom durch den zweiten Bipolartransistor 2 und es fließt ein Strom in den ersten rückgekoppelten Inverter 14 bzw. in den zweiten rückgekoppelten Inverter 15. Die Ausgangsspannung des ersten rückgekoppelten Inverters 14 wird ausgehend von dem Ruhespannungspegel in die entgegengesetzte Richtung der Ausgangsspannung des zweiten rückgekoppelten Inverters 15 ausgelenkt. Die Spannung an dem Ausgang des ersten rückgekoppelten Inverters 14 und des zweiten rückgekoppelten Inverter 15 wird entsprechend der Stromspiegelvorrichtung 32 bestehend aus den Transistoren 16, 17, 18 und 19 zusammengeführt und somit aus den gegenphasigen Spannungsverläufen an dem Kollektor 5 des ersten Bipolartransistors 1 und dem Kollektor 6 des zweiten Bipolartransistors 2 in eine unipolare Ausgangsspannung an dem Ausgangsknoten 21 umgesetzt. Durch den ersten rückgekoppelten Inverter 14 wird das Gate 22 des ersten Transistors 16 und durch den zweiten rückgekoppelten Inverter 15 wird das Gate 25 des vierten Transistors 19 angesteuert. Der Strom durch den vierten Transistor 19 fließt in den Ausgangsknoten 21 und wird mit dem Strom durch den ersten Transistor 16 verglichen, der über die Stromspiegeltransistoren 17, 18 ebenfalls in den Ausgangsknoten 21 fließt. An den Ausgangsknoten 21 wird beispielsweise ein nachfolgender Inverter geschaltet. Da es für die Funktion von Bedeutung ist, daß ein guter Gleichlauf des ersten rückgekoppelten Inverters zu dem zweiten rückgekoppelten Inverter 15 besteht, sollen die beiden rückgekoppelten Inverter 14, 15 gleich aufgebaut sein. Von Vorteil ist dabei, die benachbarte und symmetrische Anordnung des ersten rückgekoppelten Inverters 14 zu dem zweiten rückgekoppelten Inverters 15 sowie die benachbarte Lage der ersten bis vierten Transistoren 16, 17, 18 und 19 um eine möglichst geringe Variation der Transistorparameter durch die Prozessierung zu ermöglichen. Darüber hinaus ist es von Vorteil, wenn die Transistoren der beiden rückgekoppelten Inverter die ersten bis vierten Transistoren 16 bis 19 der Stromspiegelvorrichtung 32 entsprechen und die Kanalweiten der P-MOS-Transistoren und N-MOS-Transistoren das gleiche Größenverhältnis aufweisen.

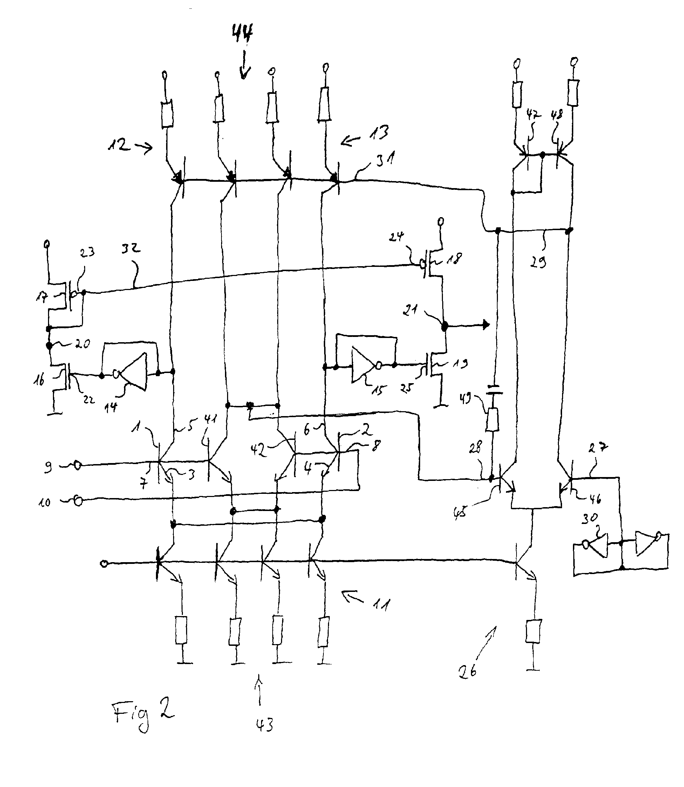

In Figur 2 ist ein detaillierteres Ausführungsbeispiel der in Figur 1 dargestellten Schaltungsanordnung gezeigt. Zusätzlich zu den in Figur 1 dargestellten Schaltungsbestandteilen sind in Figur 2 die Stromquellen 11, 12 und 13 mit Hilfe von Bipolartransistoren realisiert. Zusätzlich ist ein Operationsverstärker 26 dargestellt, der dazu geeignet ist, den Arbeitspunkt des ersten rückgekoppelten Inverters 14 und des zweiten rückgekoppelten Inverters 15 über die Steuerung der zweiten Stromquelle 12 und der dritten Stromquelle 13 einzustellen. Dazu ist die Basis eines dritten Bipolartransistors 41 mit dem ersten Eingang 9 und die Basis eines vierten Bipolartransistors 42 mit dem zweiten Eingang 10 verbunden. Die Emitter des dritten Bipolartransistors 41 und des vierten Bipolartransistors 42 sind miteinander verbunden und an eine vierte Stromquelle 43 angeschlossen. Weiterhin sind die beiden Kollektoren des dritten Bipolartransistors 41 und des vierten Bipolartransistors 42 miteinander verbunden und an eine fünfte Stromquelle 44 angeschlossen. Der Operationsverstärker 26 umfaßt einen fünften Bipolartransistor 45, einen sechsten Bipolartransistor 46, einen siebten Bipolartransistor 47 und einen achten Bipolartransistor 48. Der siebte Bipolartransistor 47 ist zwischen seiner Basis und seinem Kollektor rückgekoppelt, so daß er mit dem achten Bipolartransistor 48 einen Stromspiegel 32 bildet, der mit dem Kollektor des fünften Bipolartransistors 45 und dem Kollektor des sechsten Bipolartransistors 46 verbunden ist. Darüber hinaus sind die beiden Emitter des fünften Bipolartransistors 45 und des sechsten Bipolartransistors 46 miteinander verbunden und an eine Stromquelle angeschlossen. Die Basis des sechsten Bipolartransistors 46 stellt den ersten Operationsverstärkereingang 27 dar, der mit einem dritten rückgekoppelten Inverter 30 verbunden ist. Die Basis des fünften Bipolartransistors 45 stellt den zweiten Operationsverstärkereingang 28 dar, der mit den beiden Kollektoren des dritten Bipolartransistors 41 und des vierten Bipolartransistors 42 verbunden ist. Der Ausgang des Operationsverstärkers 29 ist über eine Frequenzgangkorrektur 49 mit dem zweiten Operationsverstärkereingang 28 verbunden. Weiterhin ist der Operationsverstärkerausgang 29 mit den Steuereingängen der zweiten Stromquelle 12, der dritten Stromquelle 13 und der fünften Stromquelle 44 verbunden.

Der Operationsverstärker 26 wird zur Regelung des Arbeitspunktes des ersten rückgekoppelten Inverters 14 und des zweiten rückgekoppelten Inverters 15 verwendet. Als Referenzgröße bzw. Führungsgröße wird das Ausgangssignal des dritten rückgekoppelten Inverters 30 verwendet und dem ersten Operationsverstärkereingang 27 zugeführt. Der Operationsverstärker 26 ist nun bestrebt, sich so einzustellen, daß an dem zweiten Operationsverstärkereingang 28 die gleiche Spannung anliegt, wie an dem ersten Operationsverstärkereingang 27. Dazu wird das an dem Operationsverstärkerausgang 29 anliegende Signal zur Steuerung der zweiten Stromquelle 12, der dritten Stromquelle 13 und der fünften Stromquelle 44 verwendet. Durch die Regelung stellt sich die Spannung an dem ersten rückgekoppelten Inverter 14 und dem zweiten rückgekoppelten Inverter 15 im Ruhezustand (keine Spannungsdifferenz zwischen dem ersten Eingang 9 und dem zweiten Eingang 10) auf die Ausgangsspannung des dritten rückgekoppelten Inverters 30 ein.

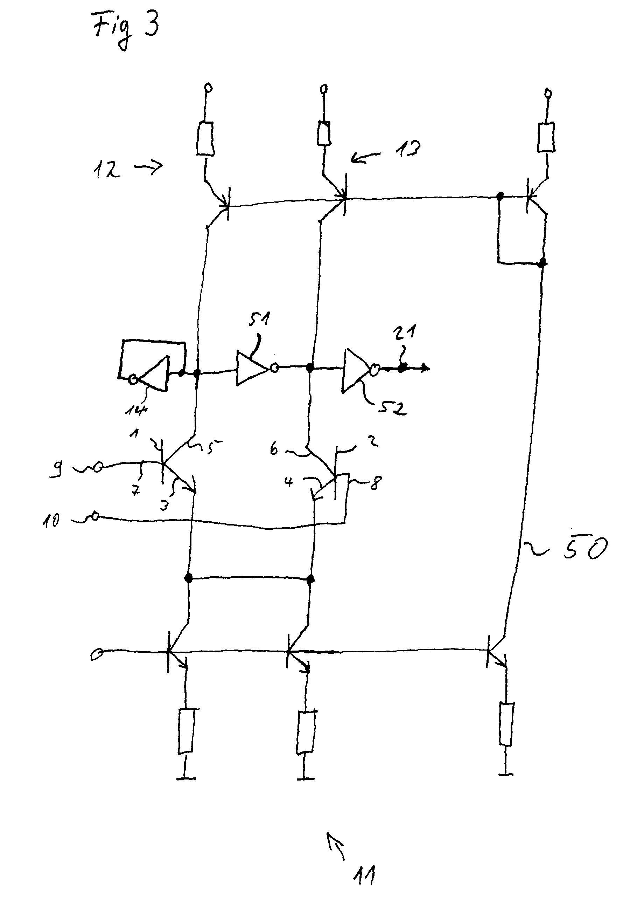

In Figur 3 ist ein weiteres Ausführungsbeispiel einer Schaltung zur Umsetzung von Logikpegeln dargestellt. Die Schaltung in Figur 3 umfaßt einen ersten Bipolartransistor 1 und einen zweiten Bipolartransistor 2. Der erste Bipolartransistor 1 weist einen Emitter 3, einen Kollektor 5 und eine Basis 7, und der zweite Bipolartransistor 2 weist einen Emitter 4 einen Kollektor 6 und eine Basis 8 auf. Der Emitter 3 des ersten Bipolartransistors 1 und der Emitter 4 des zweiten Bipolartransistors 2 sind mit einer ersten Stromquelle 11 verbunden. Der Kollektor 5 des ersten Bipolartransistors 1 ist mit einer zweiten Stromquelle 12 und der Kollektor 6 des zweiten Bipolartransistors 2 ist mit einer dritten Stromquelle 13 verbunden. Die erste Stromquelle 11 ist über eine Stromquellensteuerung 50 mit der zweiten Stromquelle 12 und der dritten Stromquelle 13 verbunden. Die Basis 7 des ersten Bipolartransistors 1 ist mit einem ersten Eingang 9 und die Basis 8 des zweiten Bipolartransistors 2 ist mit einem zweiten Eingang 10 verbunden. Weiterhin ist der Kollektor 5 des ersten Bipolartransistors 1 mit einem eingangs-ausgangsseitig rückgekoppelten Inverter 14 verbunden. Der Eingang des Inverters 14 ist mit dem Ausgang des Inverters 14 verbunden. Ein Eingang eines dritten Inverters 51 ist mit dem Kollektor 5 des ersten Bipolartransistors 1 und ein Ausgang des dritten Inverters 51 ist mit dem Kollektor 6 des zweiten Bipolartransistors 2 verbunden. Weiterhin ist der Eingang eines vierten Inverters 52 mit dem Kollektor 6 des zweiten Bipolartransistors 2 und der Ausgang des vierten Inverters 52 mit einem Ausgangsknoten 21 verbunden.

In einem Ruhezustand erzeugt der rückgekoppelte Inverter 14 an dem Kollektor 5 des ersten Bipolartransistors 1 eine Spannung, die der Umschaltspannung des Inverters 14 entspricht. Weist beispielsweise der dritte Inverter 51 die gleiche Dimensionierung wie der erste rückgekoppelte Inverter 14 auf, so ist die Spannung an dem Kollektor 6 des zweiten Bipolartransistors 2 gleich der Spannung des Kollektors 5 des ersten Bipolartransistors 1.

Wird nun eine Spannungsdifferenz zwischen dem ersten Eingang 9 und dem zweiten Eingang 10 angelegt, so ändert sich die Spannung des Kollektors 5 des ersten Bipolartransistors 1 und die Spannung des Kollektors 6 des zweiten Bipolartransistors 2 gegenläufig, was durch das Inverterverhalten des dritten Inverters 51 unterstützt wird. Weiterhin verstärkt der vierte Inverter 52 das logische Signal an dem Kollektor 6 des zweiten Bipolartransistors 2, so daß an dem Ausgangsknoten 21 ein CMOS-Logikpegel anliegt.

### Bezugszeichenliste

- 1: erster Bipolartransistor
- 2: zweiter Bipolartransistor
- 3: erster Emitter
- 4: zweiter Emitter
- 5: erster Kollektor
- 6: zweiter Kollektor
- 7: erste Basis
- 8: zweite Basis
- 9: erster Eingang
- 10: zweiter Eingang
- 11: erste Stromquelle
- 12: zweite Stromquelle
- 13: dritte Stromquelle
- 14: erster rückgekoppelter Inverter
- 15: zweiter rückgekoppelter Inverter
- 16: erster Transistor
- 17: zweiter Transistor
- 18: dritter Transistor
- 19: vierter Transistor
- 20: erster Knoten
- 21: Ausgangsknoten
- 22: Gate des ersten Transistors
- 23: Gate des zweiten Transistors
- 24: Gate des dritten Transistors
- 25: Gate des vierten Transistors
- 26: Operationsverstärker
- 27: erster Operationsverstärkereingang
- 28: zweiter Operationsverstärkereingang
- 29: Operationsverstärkerausgang
- 30: dritter rückgekoppelter Inverter
- 31: Steuereingang
- 32: Stromspiegel
- 41: dritter Bipolartransistor
- 42: vierter Bipolartransistor
- 43: vierte Stromquelle
- 44: fünfte Stromquelle
- 45: fünfter Bipolartransistor
- 46: sechster Bipolartransistor
- 47: siebter Bipolartransistor
- 48: achter Bipolartransistor
- 49: Frequenzgangkorrektur
- 50: Stromquellensteuerung
- 51: dritter Inverter
- 52: vierter Inverter

## Patentansprüche

1. Schaltungsanordnung zur Umsetzung von Logikpegeln mit:
- einem ersten Bipolartransistor (1), der einen Emitter (3), einen Kollektor (5) und eine Basis (7) aufweist;
- einem zweiten Bipolartransistor (2), der einen Emitter (4), einen Kollektor (6) und eine Basis (8) aufweist;
- wobei der Emitter (3) des ersten Bipolartransistors (1) und der Emitter (4) des zweiten Bipolartransistors (2) mit einer ersten Stromquelle (11) verbunden sind und
- der Kollektor (5) des ersten Bipolartransistors (1) mit einer zweiten Stromquelle (12) und
- der Kollektor (6) des zweiten Bipolartransistors (2) mit einer dritten Stromquelle (13) verbunden sind,
**dadurch gekennzeichnet, daß**
ein eingangs-ausgangsseitig rückgekoppelter erster Inverter (14) mit dem Kollektor (5) des ersten Bipolartransistors (1) verbunden ist und ein Ausgangsknoten (21) vom ersten rückgekoppelten Inverter (14) ansteuerbar ist.

2. Schaltungsanordnung nach Anspruch 1,
**dadurch gekennzeichnet, daß**
ein eingangs-ausgangsseitig rückgekoppelter zweiter Inverter (15) mit dem Kollektor (6) des zweiten Bipolartransistors (2) verbunden ist und der Ausgangsknoten (21) mit dem zweiten rückgekoppelten Inverter (15) ansteuerbar ist.

3. Schaltungsanordnung nach Anspruch 2,
**dadurch gekennzeichnet, daß**
der erste Inverter (14) und der zweite Inverter (15) über einen Stromspiegel (32) gekoppelt sind.

4. Schaltungsanordnung nach einem der Ansprüche 1 bis 3,
**dadurch gekennzeichnet, daß**
ein erster Transistor (16) und ein zweiter Transistor (17) an einem ersten Knoten (20) an ihren jeweiligen Drain-Gebieten miteinander verbunden sind und ein Gate (22) des ersten Transistors (16) mit dem Kollektor (5) des ersten Bipolartransistors (1) und ein Gate (23) des zweiten Transistors (17) mit dem ersten Knoten (20) verbunden ist und ein dritter Transistor (18) und ein vierter Transistor (19) an dem Ausgangsknoten (21) an ihren jeweiligen Drain-Gebieten miteinander verbunden sind und ein Gate (24) des dritten Transistors (18) mit dem Gate (23) des zweiten Transistors (17) verbunden ist und ein Gate (25) des vierten Transistors (19) mit dem zweiten rückgekoppelten Inverter (15) verbunden ist.

5. Anordnung nach einem der Ansprüche 1 bis 3,
**dadurch gekennzeichnet, daß**
ein Operationsverstärker (26) mit einem ersten Operationsverstärkereingang (27) und einem zweiten Operationsverstärkereingang (28) und einem Operationsverstärkerausgang (29) so angeordnet ist, daß der erste Operationsverstärkereingang (27) mit einem dritten eingangs-ausgangsseitig rückgekoppelten Inverter (30) verbunden ist und der Operationsverstärkerausgang mit einem Steuereingang der zweiten Stromquelle (12) und der dritten Stromquelle (13) verbunden ist.

6. Schaltungsanordnung nach Anspruch 1,
**dadurch gekennzeichnet, daß**
ein Eingang eines dritten Inverters (51) mit dem Kollektor (5) des ersten Bipolartransistors (1) und ein Ausgang des dritten Inverters (51) mit dem Kollektor (6) des zweiten Bipolartransistors (6) verbunden ist.
